Europäisches Patentamt

**European Patent Office**

**Office européen des brevets**

(11) Numéro de publication: **0 295 977 B1**

## FASCICULE DE BREVET EUROPEEN

(45) Date de publication de fascicule du brevet: **23.12.92**   (51) Int. Cl.5: **H04N 5/217**, H01L 27/14

(21) Numéro de dépôt: **88401229.5**

(22) Date de dépôt: **20.05.88**

(54) **Photosenseur à structure de transfert de trame et son utilisation dans un capteur d'images à effet de traînage réduit.**

(30) Priorité: **26.05.87 FR 8707419**

(43) Date de publication de la demande:
**21.12.88 Bulletin 88/51**

(45) Mention de la délivrance du brevet:
**23.12.92 Bulletin 92/52**

(84) Etats contractants désignés:
**DE GB NL**

(56) Documents cités:
**US-A- 4 032 976**
**US-A- 4 040 092**

**PATENT ABSTRACTS OF JAPAN, vol. 9, no. 193 (E-334)[1916], 9 août 1985, page 156 E 334; & JP-A-60 62 154 (NIPPON VICTOR K.K.) 10-04-1985**

(73) Titulaire: **THOMSON-CSF**
**51, Esplanade du Général de Gaulle**
**F-92800 Puteaux(FR)**

(72) Inventeur: **Cazaux, Yvon**
**THOMSON-CSF SCPI 19, avenue de Messine**
**F-75008 Paris(FR)**

(74) Mandataire: **Turlèque, Clotilde et al**
**THOMSON-CSF SCPI**
**F-92045 PARIS LA DEFENSE CEDEX 67(FR)**

# Description

L'invention se rapporte aux photosenseurs matriciels à l'état solide et plus particulièrement à une amélioration aux photosenseurs matriciels à l'état solide du type transfert de trame, en ce qui concerne l'effet de traînage ou "smearing" dans la littérature technique en anglais.

Cet effet de "smearing" se traduit sur le signal vidéo issu du capteur, par une pollution au dessus et au dessous des zones illuminées. Il constitue une des principales limitations de la structure à transfert de trame.

Classiquement pour résoudre ce problème on place un obturateur devant la zone photosensible pour éviter tout rayonnement parasite pendant le transfert de la zone image à la zone mémoire, ou bien on essaie d'augmenter la fréquence de transfert vertical pour limiter cet effet, proportionnel au temps de passage sous une ligne éclairée pendant le transfert vertical.

La première solution est lourde et la seconde est difficile à mettre en oeuvre, notamment pour les photosenseurs de grandes dimensions où la fréquence de transfert vertical ne peut pas être augmentée de façon suffisante sans dégradation des performances du capteur.

L'invention a pour objet un photosenseur à transfert de trame dont la structure est modifiée et qui permet de supprimer l'effet de traînage au dessus d'une zone éclairée, dans un fond obscur.

Selon l'invention, un photosenseur à structure de transfert de trame comportant une zone image formée par une matrice de photosites pourvue de registres à transfert de charges verticaux et d'électrodes de commande de transfert horizontales, une zone mémoire et un registre de sortie, est caractérisé en ce que chaque photosite de la matrice photosensible, limité par des grilles d'isolement verticales et localisé sous une électrode de commande horizontale, est pourvu d'un transistor MOS pour évacuer en un temps bref les charges parasites qui sont présentes en fin de transfert de trame, par commande des électrodes de commande de ces transistors.

L'invention a également pour objet un capteur d'images, à effet de traînage réduit dans une partie de l'image, comportant un tel photosenseur.

L'invention est notamment applicable aux capteurs d'image utilisés pour la poursuite de cible, ou "tracking" dans la littérature technique en anglais, où l'image est constituée principalement d'un spot suréclairé dans un fond continu.

L'invention sera mieux comprise et d'autres caractéristiques apparaîtront à l'aide de la description qui suit en référence aux figures annexées.

La figure 1 représente schématiquement l'organisation, classique, d'un photosenseur à transfert de trame ;

Les figures 2a, 2b, 2c et 2d illustrent la formation de l'effet de traînage et la figure 2e l'image résultante pour un spot éclairé sur un fond obscur, et les signaux correspondants pour deux lignes et une colonne ;

Les figures 3a et 3b sont des schémas détaillés d'une partie de la zone image d'un photosenseur selon l'invention, respectivement en plan et en coupe selon une ligne ;

Les figures 4a et 4b représentent la configuration des puits de potentiel avant et après l'application d'une impulsion qui supprime le traînage résiduel, pour un pixel tel que représenté sur les figures 3a et 3b ;

La figure 5 est le chronogramme des signaux de commande correspondants ;

La figure 6 illustre l'image d'un spot éclairé sur un fond obscur, obtenue par un photosenseur selon l'invention.

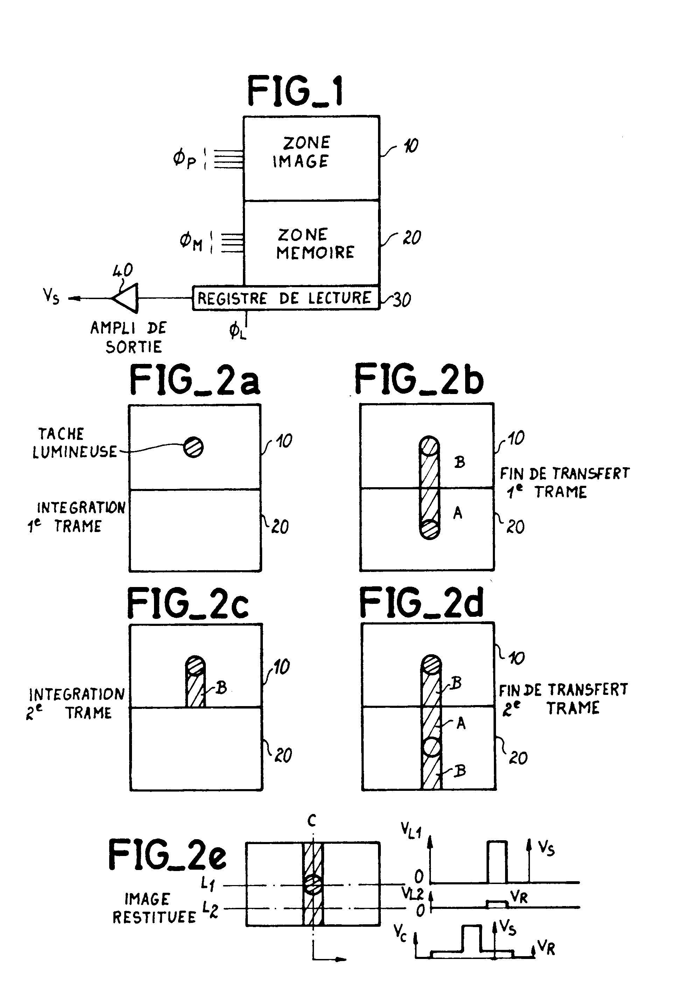

La figure 1 représente l'organisation classique d'un photosenseur à transfert de trame.

Le dispositif est principalement constitué de trois sous ensembles :

la zone image 10 et ses électrodes de commande $\phi_P$, la zone mémoire 20 et ses électrodes de commande $\phi_M$, et le registre de lecture 30, et ses électrodes de commande de lecture $\phi_L$ et l'amplificateur de sortie 40 qui fournit le signal vidéo. Le principe de fonctionnement du photosenseur est le suivant :

- Pendant le temps d'intégration Ti, les charges engendrées par les photons incidents sont intégrées en zone image. La zone image est constituée de registres à transfert de charge verticaux disposés côte à côte et commandés simultanément par les électrodes $\phi_P$.

- En fin d'intégration, l'information contenue en zone image est transférée dans la zone mémoire.

La zone mémoire est elle aussi constituée de registres à transfert de charge verticaux commandés par des électrodes communes $\phi_M$.

Le transfert en zone mémoire, de l'information contenue en zone image, est obtenu par la commande simultanée des électrodes $\phi_P$ et $\phi_M$. Ce transfert vertical est réalisé à la fréquence Fv = 1/Tv. Le temps Tv correspond au temps nécessaire pour le décalage d'une ligne.

- La transfert en zone mémoire étant achevé, l'intégration en zone image recommence alors que l'information contenue en zone mémoire est évacuée ligne après ligne par le registre de lecture à l'aide de la commande des électrodes $\phi_M$ et $\phi_L$.

En fin d'intégration, pendant le transfert vertical de la zone image vers la zone mémoire, les informations des différentes lignes sont décalées alors que l'éclairement incident continue à générer des informations en zone image.

Ceci se traduit par un mélange des informations intégrées pendant le temps d'intégration Ti, avec les informations collectées pendant le temps de transfert vertical.

La dégradation ainsi introduite sur le signal vidéo est appelée traînage ou "smearing".

Elle est proportionnelle à la période de transfert vertical et au nombre de lignes éclairées.

Les figures 2a, 2b, 2c et 2d permettent d'expliquer par un exemple simple la formation de la dégradation introduite par l'effet de smearing, dans le cas de capteurs classiques, lorsque l'information est constituée d'une simple tache lumineuse s'étendant sur N lignes.

- Fig. 2a : à l'instant to, une tâche lumineuse est appliquée sur la zone image 10 du capteur qui l'intègre pendant le temps Ti. La zone mémoire 20 est vide, le senseur étant plongé dans l'obscurité avant l'instant to.
- Fig. 2b : le signal présent en zone image 10 vient d'être transféré dans la zone mémoire 20. L'intégration d'une nouvelle trame débute.

Les zones A et B correspondent aux étages des registres à transfert de charge pollués pendant les transferts de la zone image 10 vers la zone mémoire 20 par l'éclairement qui se prolonge durant le transfert.

- Fig. 2c : situation en fin d'intégration. Les informations de la trame précédente, contenues dans la zone mémoire 20, ont été évacuées, et cette zone est vide.
- Fig. 2d : configuration après le transfert de la zone image vers la zone mémoire. Le signal en zone mémoire contient les pollutions en A et B.

Il en est de même de toutes les trames suivantes

- La figure 2e représente l'effet de traînage sur l'image restituée dans le même cas. Il se traduit par un traînage au dessus et au dessous de zone éclairée. Ce traînage correspond à un niveau de tension résiduelle $V_R$ constant quelle que soit la ligne ; il est proportionnel au temps de passage des étages vides sous la zone illuminée, pendant les transferts verticaux. Le niveau résiduel $V_R$, dû à l'effet de traînage, peut s'exprimer de la façon suivante :
  - pour un éclairement E inférieur à l'éclairement de saturation Esat du photosenseur :

$$VR = N.\frac{Tv}{Ti}.Vs, \quad (1)$$

  - pour un éclairement E supérieur à Esat :

$$VR = N.\frac{TV}{Ti}.Vsat.\frac{E}{Esat}(2)$$

avec :
- Vs : niveau du signal sur les pixels éclairés pendant Ti à l'éclairement E
- Vsat : niveau de saturation des pixels pour l'éclairement saturation Esat
- Tv = temps de passage sous une ligne éclairée
- Ti = temps d'intégration
- N = nombre de lignes éclairées
- N.Tv = temps de passage des étages vides sous la tache lumineuse pendant les transferts verticaux.

Les signaux vidéo $V_{L1}$ et $V_{L2}$ associés à deux lignes $L_1$ et $L_2$, l'une choisie au niveau du spot éclaire l'autre choisie au niveau d'une zone de traînage et le signal $V_c$ correspondant à une colonne C ont été représentés sur la figure 2e.

D'après les expressions (1) et (2), l'augmentation de la fréquence de transfert vertical permet de réduire le niveau résiduel $V_R$ de traînage.

Toutefois, comme indiqué ci-dessus l'augmentation de cette fréquence est limitée du fait des constantes de temps réparties de ligne, responsables de la dégradation de la résolution verticale lorsque la fréquence de transfert devient trop importante. Pour un capteur au format 2/3 de pouce, la fréquence de transfert verticale ne peut guère excéder 1 à 2 MHz.

La tension résiduelle correspondant au mode télévision suivant les normes CCIR où le temps d'intégration Ti = 20ms vaut, pour 100 lignes éclairées, : $V_R = 5.10^{-3}Vs$. Si les mêmes lignes sont suréclairées 100 fois par rapport au niveau de saturation, la tension résiduelle en présence d'un dispositif anti-éblouissement devient :

$$V_R = \frac{Vsat}{2}$$

Pour les applications travaillant hors normes CCIR avec des temps d'intégration beaucoup plus courts, l'effet de traînage devient très vite pénalisant.

Par exemple pour un temps d'intégration Ti = 1ms, pour N = 100 lignes éclairées à E<Esat, et avec une fréquence de transfert verticale Fv = 1MHz : $V_R = 0,1 .Vsat$

Si les mêmes lignes sont suréclairées 100 fois par rapport au niveau de saturation et avec un dispositif d'anti-éblouissement E = 100 Esat et VR = Vsat

En conséquence, toute la zone située au dessus et au dessous de la tâche est saturée et le dispositif d'anti-éblouissement devient inutile.

La présente invention propose une solution permettant de préserver intactes les zones situées au dessus des régions éclairées sans dégradation des performances électrooptiques.

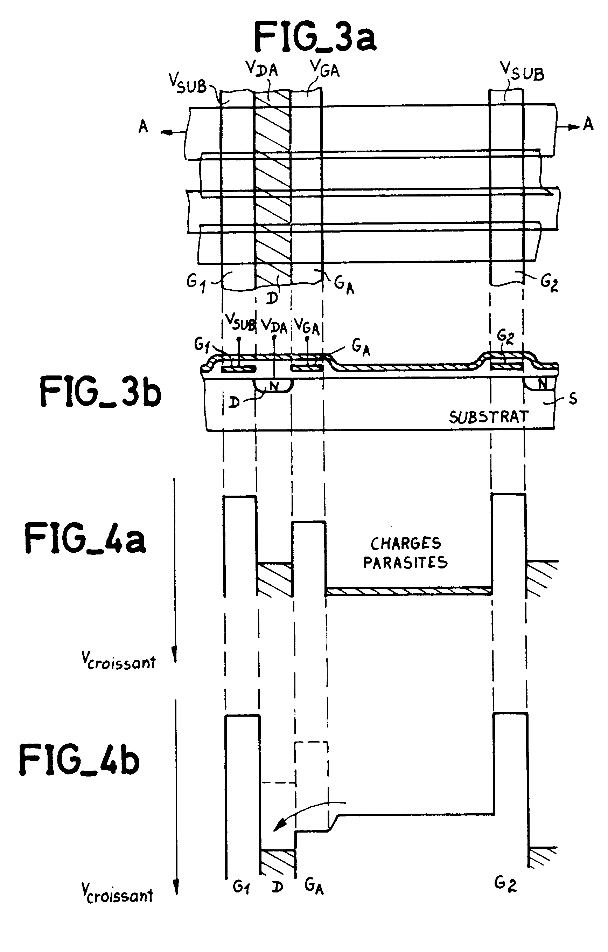

L'invention consiste à réaliser un transistor MOS à côté de chaque point élémentaire, comme représenté sur les figures 3a et 3b qui représentent respectivement un photosite ou zone élémentaire de la zone image 10 respectivement en plan, et en coupe transversale selon l'axe A de la figure 3a. Entre deux grilles d'isolement verticales $G_1$ et $G_2$ limitant un photosite et portées au potentiel du substrat $V_{SUB}$ est réalisé un transistor MOS, la zone restante définissant la largeur utile du registre à transfert de charge vertical. Pour cela une zone de diffusion D dopée M est réalisée dans le substrat S pour constituer le drain du transistor porté à la tension de drain $V_{DA}$, et une grille $G_A$ s'étendant parallèlement aux grilles d'isolement et formant la grille du transistor MOS est déposée sur le substrat. Cette grille est polarisée à la tension $V_{GA}$. L'ensemble est recouvert des électrodes de commande horizontales recevant les signaux de commande de transfert $\phi_P$ des registres à transfert de charge verticaux. Les différents niveaux, substrat, grilles verticales et grilles horizontales, sont séparés par de l'oxyde.

Dans la plupart des cas, les transistors MOS sont deplétés (canal enterré) et les électrodes $G_A$ et D sont commandées séparemment, $V_{GA} \neq V_{DA}$.

Dans le cas de transistors enrichis, la tension de seuil est positive et $V_{DA}$ et $V_{GA}$ peuvent être connectées ensemble.

L'application d'une impulsion positive sur les commandes de ces transistors, en début de trame, permet d'éliminer le traînage situé au dessus des zones éclairées sans affecter le signal utile.

Il est nécessaire pour cela que l'amplitude de l'impulsion soit telle qu'elle permette l'évacuation totale des charges parasites présentes dans les photosites en fin de transfert vertical, alors que la zone image 10 est complètement vidée de ses informations utiles.

Les figures 4a et 4b représentent la configuration des puits de potentiel d'un pixel pollué par l'éclairement parasite, avant et après l'application de cette impulsion.

Le fait d'évacuer, en fin de transfert vertical, les charges contenues en zone image dans les drains des transistors MOS décrits précédemment, permet d'éliminer totalement la dégradation de la zone B, fig. 2b. La zone image étant vidée des informations utiles, ces dernières ne sont pas affectées par cette impulsion. L'intégration durant la seconde trame s'effectue alors dans les mêmes conditions que l'intégration de la première trame, sans traînage résiduel présent en zone image. Seul subsiste sur le signal vidéo restitué, le traînage dans les zones A, sous l'image du spot éclairé.

Le chronogramme des signaux à générer pour réaliser cette amélioration est représenté sur la figure 3 qui représente le signal de suppression trame, les impulsions de commande de transfert dans les registres verticaux à transfert de charge, et les impulsions pour l'évacuation des charges résiduelles dans la zone image 10 appliquées aux grilles des transistors MOS.

Selon l'invention, la durée de l'impulsion est fixe ; elle peut être très courte et contenue dans le temps de retour trame.

Le niveau bas de cette impulsion peut être ajusté afin de réaliser un anti-éblouissement contre les forts niveaux d'éclairement. L'invention permet de conserver les informations de faible niveau tout en supprimant le traînage sur le haut de l'image.

Dans le cas d'application à la poursuite de cible (tracking), l'image est constituée principalement par un spot sur fond continu.

Le traînage peut être tel que l'objet soit perdu dans la traînée, comme représenté sur la figure 2e.

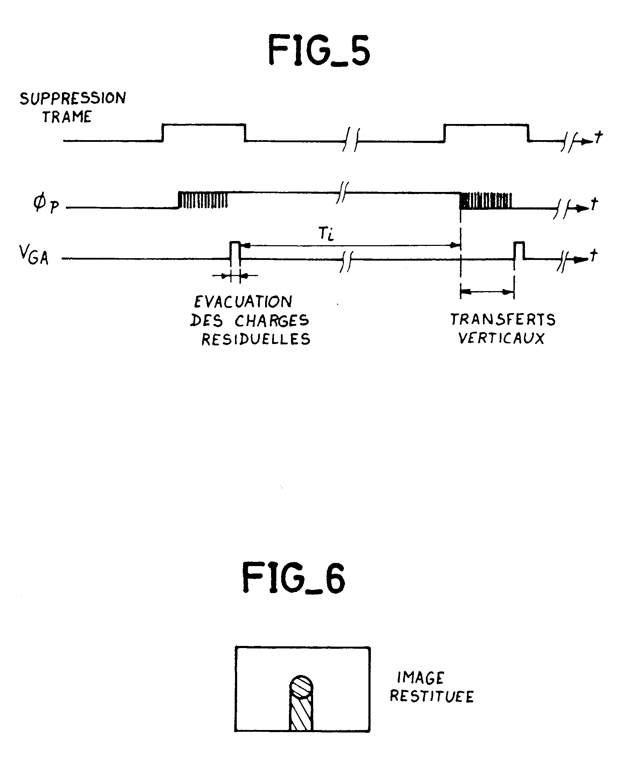

La figure 6 représente l'image résultante obtenue par un photosenseur selon l'invention dans les mêmes conditions d'éclairement que celles définies précédemment.

Comme le montre cette figure, l'invention permet de localiser l'objet, même pour des conditions où le traînage serait très important (de niveau égal à l'objet). L'objet se situe en effet au sommet de la trainée.

Dans le cas d'image classique, la gène dûe au traînage est principalement localisée dans les zones d'intensité très forte. L'invention limite cette gène au bas de l'image en préservant intactes les informations du haut de l'image.

L'invention concerne toute structure de type transfert de trame. Elle nécessite un dispositif permettant l'évacuation en un temps bref des charges contenues dans les pixels.

Elle est indépendante du mode de fonctionnement des registres à transfert de charges verticaux et de celui du registre horizontal.

## Revendications

1. Photosenseur à structure de transfert de trame comportant une zone image (10) formée par une matrice de photosites pourvue de registres à transfert de charges verticaux et d'électrodes de commande de transfert horizontales ($\phi_P$), une zone mémoire (20) et un registre de sortie (30), caractérisé en ce que chaque photosite de la matrice photosensible, limité par des grilles d'isolement ($G_1$, $G_2$) verticales et localisé sous une électrode de commande horizontale ($\phi_P$), est pourvu d'un transistor MOS pour évacuer en un temps bref les charges parasites qui sont présentes en fin de transfert de trame par commande des électrodes de commande de ces transistors..

**2.** Photosenseur selon la revendication 1, caractérisé en ce que le transistor MOS associé à chaque photosite est constitué par l'une des grilles d'isolement formant source, une zone dopée du substrat formant drain D, et une grille de commande ($G_A$),ce transistor étant destiné à recevoir une impulsion de commande courte en fin de transfert de trame, d'amplitude et de durée fixées, pour évacuer les charges vers le drain.

**3.** Photosenseur selon la revendication 2, caractérisé en ce que les transistors étant deplétés, le drain et la grille de commande reçoivent des tensions de commande $V_{DA}$ et $V_{GA}$ différentes.

**4.** Capteur d'images à effet de traînage réduit dans une partie de l'image comportant un photosenseur selon l'une des revendications 1 et 2.

**5.** Capteur d'images selon la revendication 4 pour poursuite de cible, où la zone de l'image au dessus de la cible est dépourvue d'effet de traînage.

## Claims

**1.** A photosensor with frame transfer structure comprising an image zone (10) formed by a matrix of photo-sites provided with vertical charge transfer registers and horizontal transfer control electrodes ($\phi_P$), a memory zone (20) and an output register (30), characterised in that each photo-site of the photo-sensitive matrix, limited by vertical insulation grids ($G_1$, $G_2$) and located under a horizontal control electrode ($\phi_P$), is provided with an MOS transistor for clearing in a brief period the stray charges which are present at the end of the frame transfer controlled by the control electrodes of these transistors.

**2.** A photosensor according to Claim 1, characterised in that the MOS transistor associated with each photo-site is composed of one of the insulation grids forming the source, a doped zone of the substrate forming the drain D, and a control grid ($G_A$),this transistor being intended to receive a short control pulse at the end of the frame transfer, of fixed amplitude and duration, in order to clear the charges to the drain.

**3.** A photosensor according to Claim 2, characterised in that, the transistors being depleted, the drain and the control grid receive different control voltages $V_{DA}$ and $V_{GA}$.

**4.** An image detector with low smearing effect in a portion of the image comprising a photosensor according to one of Claims 1 and 2.

**5.** An image detector according to Claim 4 for target tracking, where the zone of the image above the target is free from any smearing effect.

## Patentansprüche

**1.** Fotodetektor mit Rahmentransferstruktur, mit einer Bildzone (10), die aus einer Matrix von lichtempfindlichen Elementarzonen besteht und mit vertikalen Ladungstransferregistern sowie horizontalen Transfersteuerelektroden ($\phi_P$) gebildet wird, mit einer Speicherzone (20) und einem Ausgangsregister (30), dadurch gekennzeichnet, daß jede lichtempfindliche Elementarzone der Matrix, die durch vertikale Isoliergates ($G_1$, $G_2$) begrenzt ist und unter einer horizontalen Steuerelektrode ($\phi_P$) liegt, mit einem MOS-Transistor zur schnellen Abfuhr der Störladungen versehen ist, die am Ende des Rahmentransfers noch vorhanden sind, und zwar durch Steuerung der Steuerelektroden dieser Transistoren.

**2.** Fotodetektor nach Anspruch 1, dadurch gekennzeichnet, daß der jeder lichtempfindlichen Elementarzone zugeordnete MOS-Transistor aus einem die Sourceelektrode bildenden der Isoliergates, einer die Drainelektrode D bildenden dotierten Zone des Substrats und einem Steuergate ($G_A$) gebildet wird und dazu bestimmt ist, einen kurzen Steuerimpuls bestimmter Amplitude und Dauer am Ende des Rahmentransfers zugeführt zu erhalten, um die Ladungen zur Drainelektrode abzuführen.

**3.** Fotodetektor nach Anspruch 2, dadurch gekennzeichnet, daß die Transistoren vom Abreicherungstyp sind und die Drain- und Gateelektroden unterschiedliche Steuerspannung $V_{DA}$ und $V_{GA}$ zugeführt erhalten.

**4.** Bildaufnahmevorrichtung mit verringertem Schmiereffekt in einem Teil des Bildes unter Verwendung eines Fotodetektors nach einem der Ansprüche 1 und 2.

**5.** Bildaufnahmevorrichtung nach Anspruch 4 für die Verfolgung eines Ziels, wobei die Bildzone oberhalb des Ziels keinen Schmiereffekt zeigt.

# FIG_1

ZONE IMAGE — 10

$\phi_P$

ZONE MEMOIRE — 20

$\phi_M$

40

$V_S$

AMPLI DE SORTIE

REGISTRE DE LECTURE — 30

$\phi_L$

# FIG_2a

TACHE LUMINEUSE — 10

INTEGRATION 1$^e$ TRAME — 20

# FIG_2b

B — 10

A — 20

FIN DE TRANSFERT 1$^e$ TRAME

# FIG_2c

INTEGRATION 2$^e$ TRAME

B — 10

20

# FIG_2d

B — 10

A

B — 20

FIN DE TRANSFERT 2$^e$ TRAME

# FIG_2e

C

IMAGE RESTITUEE

L1

L2

$V_{L1}$

0

$V_S$

$V_{L2}$

0

$V_R$

$V_C$

$V_S$

$V_R$

# FIG_3a

$V_{SUB}$   $V_{DA}$   $V_{GA}$   $V_{SUB}$

A

A

$G_1$   D   $G_A$   $G_2$

## FIG_3b

$V_{SUB}$ $V_{DA}$ $V_{GA}$

$G_1$   $G_A$   $G_2$

D   N

N   S

SUBSTRAT

## FIG_4a

CHARGES
PARASITES

$V_{croissant}$

## FIG_4b

$G_1$   D   $G_A$   $G_2$

$V_{croissant}$

# FIG_5

SUPPRESSION
TRAME

$\phi_P$

$V_{GA}$

$T_i$

EVACUATION
DES CHARGES
RESIDUELLES

TRANSFERTS
VERTICAUX

# FIG_6

IMAGE
RESTITUEE